# EUROPEAN PATENT APPLICATION

(11) **EP 3 450 278 A1**
(43) Date of publication of application: **06.03.2019**
(21) Application number: 17789667.7
(22) Date of filing: 27.04.2017
(51) Int. Cl.: B61C 17/00, B60L 15/00, H02M 7/48

(54) **POWER CONVERSION DEVICE FOR RAILROAD VEHICLE**

(30) Priority: 28.04.2016 JP 2016092078
(71) Applicant: Kabushiki Kaisha Toshiba, Minato-ku Tokyo 105-8001 (JP); Toshiba Infrastructure Systems & Solutions Corporation, Kawasaki-shi, Kanagawa 212-8585 (JP)
(72) Inventor: SUZUKI Satoko, Tokyo 105-8001 (JP)
(74) Representative: AWA Sweden AB
(86) International application number: PCT/JP2017/016747
(87) International publication number: WO 2017/188385

(57) **Abstract**

According to one embodiment, a power converter for a railroad vehicle includes a semiconductor device, a first heat receiving member, a reactor and a resistor, a second heat receiving member, a coolant circulation loop, and a heat exchanger. The semiconductor device constitutes a main circuit unit that carries out power conversion. The semiconductor device is attached to the first heat receiving member. The reactor and the resistor constitute an auxiliary circuit unit that carries out power conversion. The reactor and the resistor are attached to the second heat receiving member. The coolant circulation loop causes a coolant to flow through the first heat receiving member and the second heat receiving member. The heat exchanger allows heat exchange with respect to the coolant to occur.

## Description

### FIELD

Embodiments of the present invention relate to a power converter for a railroad vehicle.

### BACKGROUND

Power converters for converting between alternating current (AC) power and direct current (DC) power are mounted on a railroad vehicle. In power converters for a railroad vehicle, a main circuit unit such as an inverter, a converter, or the like is constituted by semiconductor devices such as insulated gate bipolar transistors (IGBTs), diodes, or the like. Furthermore, this type of power converter includes an auxiliary circuit unit having reactors and resistors which inhibit harmonics, improving a power factor, or the like.

Since semiconductor devices in the main circuit unit of the power converter may generate high temperatures during a switching operation or the like, the main circuit unit is often cooled by circulating a coolant. In a power converter that cools the main circuit unit with a coolant, semiconductor devices are attached to a heat receiving member (heat sink) having a heat exchange portion exchanging heat with a coolant, and the heat receiving member is connected to a coolant circulation loop. In the coolant circulation loop, a coolant stored in a reservoir is circulated by a pump, and heat taken from semiconductor devices to be cooled is radiated to the outside by a heat exchanger.

The main circuit unit having semiconductor devices is disposed in a sealed chamber which is sealed from the outside of the vehicle, and the heat exchanger and the auxiliary circuit unit having reactors and resistors are disposed in a non-sealed chamber (air channel) which is not sealed from the outside of the vehicle.

In such a power converter for a railroad vehicle, the main circuit unit having semiconductor devices can be efficiently cooled by the coolant circulation loop. However, since reactors and resistors, which are heat generating components of the auxiliary circuit unit, are cooled by air-cooling in the non-sealed chamber, components mounted on the auxiliary circuit unit may easily become contaminated by the outside air and an overall size of the air-cooling structure tends to be large. Therefore, in such a power converter, there is a concern of deterioration in performance of the components mounted on the auxiliary circuit unit due to use over time, and increase in overall size of the device.

### PRIOR ART DOCUMENTS

### PATENT DOCUMENTS

[Patent Document 1] Japanese Unexamined Patent Application, First Publication No. 2005-287214

### SUMMARY

### PROBLEMS TO BE SOLVED BY THE INVENTION

Problems to be solved by the invention is to provide a power converter for a railroad vehicle in which deterioration in performance of components mounted on an auxiliary circuit unit due to use over time, and increase in overall size of the device are able to be avoided.

### MEANS FOR SOLVING THE PROBLEMS

According to one embodiment, a power converter for a railroad vehicle includes a semiconductor device, a first heat receiving member, a reactor and a resistor, a second heat receiving member, a coolant circulation loop, and a heat exchanger. The semiconductor device constitutes a main circuit unit that carries out power conversion. The semiconductor device is attached to the first heat receiving member. The reactor and the resistor constitute an auxiliary circuit unit that carries out power conversion. The reactor and the resistor are attached to the second heat receiving member. The coolant circulation loop causes a coolant to flow through the first heat receiving member and the second heat receiving member. The heat exchanger allows heat exchange with respect to the coolant to occur.

### BRIEF DESCRIPTION OF THE DRAWINGS

FIG. 1 is a schematic view showing a railroad vehicle in which a power converter of a first embodiment is mounted when viewed from a lateral side.
FIG. 2 is a schematic view showing a power converter of a second embodiment when viewed from a lateral side.
FIG. 3 is a schematic view showing a power converter of a third embodiment when viewed from a lateral side.
FIG. 4 is a schematic view showing a power converter of a fourth embodiment when viewed from a lateral side.
FIG. 5 is a schematic view showing a power converter of a fifth embodiment when viewed from a lateral side.

### DETAILED DESCRIPTION

Hereinafter, a power converter for a railroad vehicle according to an embodiment will be described with reference to the drawings.

### (First Embodiment)

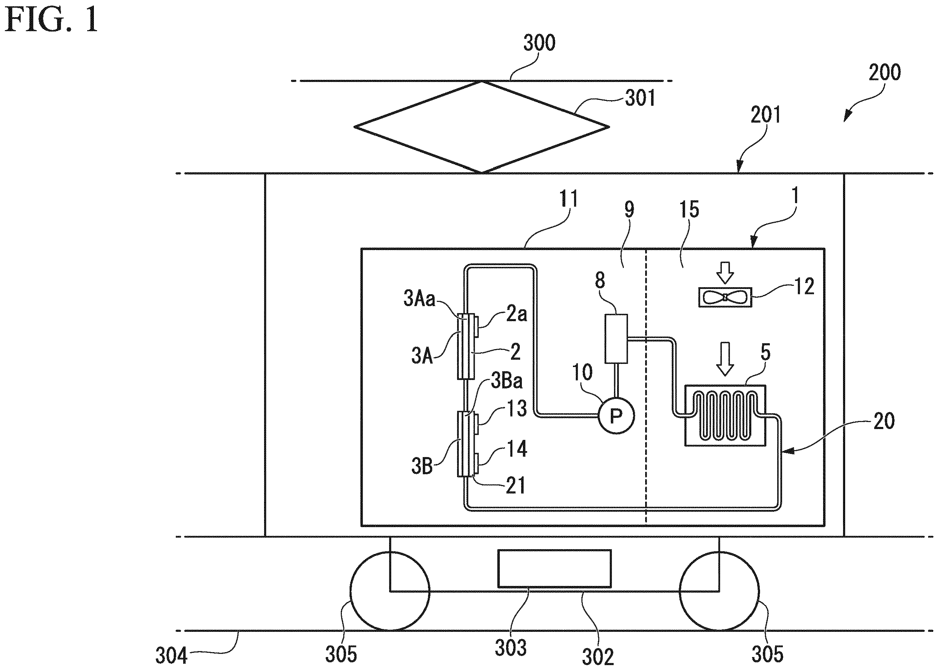

FIG. 1 is a schematic view showing a railroad vehicle 200 in which a power converter 1 of a first embodiment is mounted when viewed from a lateral side.

In the railroad vehicle 200, wheels 305 rolling on rails 304 are driven by a motor 303. The motor 303 and the wheels 305 are installed below a vehicle body 201 with a truck 302 therebetween. A pantograph 301 is installed on an upper portion of the vehicle body 201. The railroad vehicle 200 is supplied with power from an overhead line 300 via the pantograph 301.

In the railroad vehicle 200, the power converter 1 is mounted inside the vehicle body 201. The power converter 1, for example, converts alternating current (AC) power supplied from the overhead line 300 via the pantograph 301 to a direct current (DC), and then converts the DC to desired AC power again to supply power to the motor 303 for vehicle driving.

In the power converter 1, a circuit that carries out power conversion and a cooling mechanism are accommodated in a housing 11. An interior of the housing 11 is partitioned into a sealed chamber 9 which is sealed from the outside of the vehicle and a non-sealed chamber 15 (for example, an air channel) which is not sealed from the outside of the vehicle. The non-sealed chamber 15 is configured to appropriately communicate with the outside of the vehicle via ventilation holes or the like which is not shown in figure so that heat can be exchanged between outside air and the non-sealed chamber 15.

In the power converter 1, a main circuit unit 2 such as an inverter, a converter, or the like is constituted by a semiconductor device 2a such as an insulated gate bipolar transistor (IGBT), a diode, or the like. The main circuit unit 2 is attached to a main circuit heat sink 3A serving as a first heat receiving member. The main circuit heat sink 3A includes a heat exchange portion 3Aa into which a coolant is introduced from the outside. The heat exchange portion 3Aa performs heat exchange between the heat exchange portion 3Aa and the coolant.

The heat exchange portion 3Aa of the main circuit heat sink 3A is connected to a coolant circulation loop 20. In the coolant circulation loop 20, a coolant stored in a reservoir tank 8 is circulated using the power of a pump 10. In the coolant circulation loop 20, the heat exchange portion 3Aa of the main circuit heat sink 3A is connected to a downstream side of the pump 10. Also, an upstream side of the reservoir tank 8 of the coolant circulation loop 20 is connected to a heat exchanger 5 (radiator) disposed in the non-sealed chamber 15. The heat exchanger 5 exchanges heat between a coolant returned toward the reservoir tank 8 and air (outside air) in the non-sealed chamber 15. Heat of the coolant flowing through the coolant circulation loop 20 is radiated in the heat exchanger 5.

Furthermore, a blower 12 capable of blowing forced air to the heat exchanger 5 is installed in the non-sealed chamber 15.

Also, the power converter 1 includes an auxiliary circuit unit 21 that inhibits harmonics, improves a power factor, or the like. The auxiliary circuit unit 21 includes a reactor 13 and a resistor 14. Although a heat generation rate of the reactor 13 and the resistor 14 is small as compared with that of the semiconductor device 2a of the main circuit unit 2, the reactor 13 and the resistor 14 generate heat when power is supplied. The auxiliary circuit unit 21 is attached to an auxiliary circuit heat sink 3B serving as a second heat receiving member. The auxiliary circuit heat sink 3B includes a heat exchange portion 3Ba into which a coolant is introduced from the outside. The heat exchange portion 3Ba performs heat exchange between the heat exchange portion 3Ba and the coolant.

The heat exchange portion 3Ba of the auxiliary circuit heat sink 3B is connected in series to a downstream side of the main circuit heat sink 3A in the coolant circulation loop 20.

In the power converter 1, the main circuit heat sink 3A to which the main circuit unit 2 is attached and the auxiliary circuit heat sink 3B to which the auxiliary circuit unit 21 is attached are disposed in the sealed chamber 9 together with the reservoir tank 8 and the pump 10. In the coolant circulation loop 20, only the heat exchanger 5 is disposed in the non-sealed chamber 15.

In the railroad vehicle 200 according to the present embodiment, when power is supplied from the overhead line 300 via the pantograph 301, power conversion is performed in the main circuit unit 2 and the auxiliary circuit unit 21 of the power converter 1, and the motor 303 is driven by the converted power. In the main circuit unit 2 of the power converter 1, the semiconductor device 2a generates high temperature heat during power conversion, but heat is exchanged between a coolant in the coolant circulation loop 20 and the main circuit heat sink 3A in the main circuit heat sink 3A to which the main circuit unit 2 is attached, and thereby the main circuit unit 2 is cooled. At this time, the reactor 13 and the resistor 14 generate heat in the auxiliary circuit unit 21 of the power converter 1, but heat is exchanged between a coolant in the coolant circulation loop 20 and the auxiliary circuit heat sink 3B in the auxiliary circuit heat sink 3B to which the auxiliary circuit unit 21 is attached, and thereby the auxiliary circuit unit 21 is cooled.

The coolant that has absorbed heat in the main circuit unit 2 and the auxiliary circuit unit 21 goes on to the heat exchanger 5 in the coolant circulation loop 20, and exchanges heat with air in the non-sealed chamber 15 in the heat exchanger 5. The coolant is thereby cooled and returned to the pump 10 via the reservoir tank 8.

As described above, the power converter 1 according to the present embodiment includes the main circuit unit 2 having the semiconductor device 2a, the main circuit heat sink 3A to which the main circuit unit 2 is attached, the auxiliary circuit unit 21 having the reactor 13 and the resistor 14, the auxiliary circuit heat sink 3B to which the auxiliary circuit unit 21 is attached, and the coolant circulation loop 20 which causes a coolant to flow through the main circuit heat sink 3A and auxiliary circuit heat sink 3B. Therefore, not only the semiconductor device 2a of the main circuit unit 2 but also the reactor 13 and the resistor 14 of the auxiliary circuit unit 21 can be efficiently cooled by the coolant circulation loop 20.

Furthermore, in the power converter 1 according to the present embodiment, the main circuit heat sink 3A and the auxiliary circuit heat sink 3B are disposed in the sealed chamber 9, and the heat exchanger 5 of the coolant circulation loop 20 is disposed in the non-sealed chamber 15. Therefore, it is possible to prevent the reactor 13 and the resistor 14 of the auxiliary circuit unit 21 from being contaminated by outside air.

Furthermore, in the power converter 1 according to the present embodiment, the auxiliary circuit heat sink 3B is connected in series to the downstream side of the main circuit heat sink 3A in a coolant path of the coolant circulation loop 20. Therefore, a temperature rise of the coolant accompanying cooling of the auxiliary circuit unit 21 does not affect cooling of the main circuit unit 2. Therefore, when the power converter 1 according to the present embodiment is employed, it is possible to preferentially cool the main circuit unit 2 having a high heat generation rate.

### (Second Embodiment)

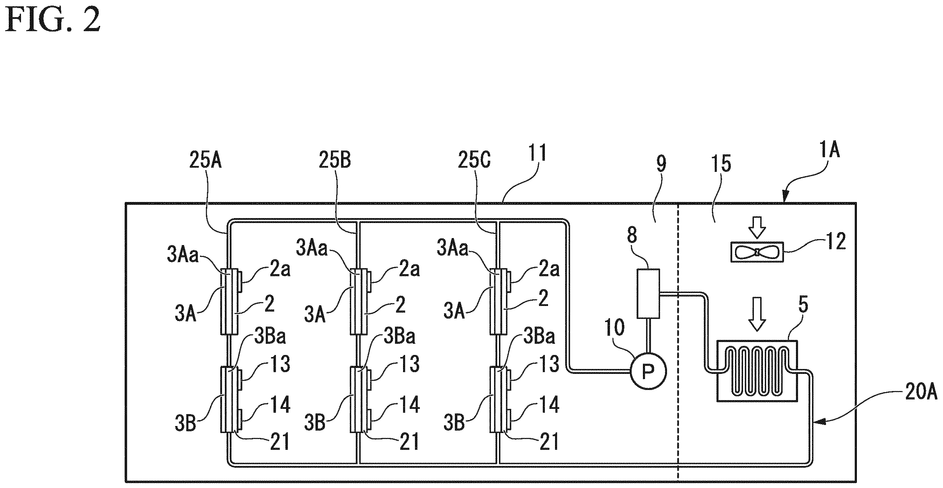

FIG. 2 is a schematic view showing a power converter 1A of a second embodiment when viewed from a lateral side. In each of the embodiments described below, portions the same as those in the first embodiment are denoted by the same reference signs.

Basic configurations of the power converter 1A of the second embodiment are substantially the same as those of the first embodiment, but three branching-off coolant paths 25A, 25B, and 25C (first coolant path, second coolant path, and third coolant path) are provided on a downstream side of a pump 10 of a coolant circulation loop 20A, and a main circuit heat sink 3A (first heat receiving member) and an auxiliary circuit heat sink 3B (second heat receiving member) are connected to each of the coolant paths 25A, 25B, and 25C. The auxiliary circuit heat sink 3B is connected in series to a downstream side of the main circuit heat sink 3A in each of the coolant paths 25A, 25B and 25C. Also, the three branched-off coolant paths 25A, 25B, and 25C join again to be connected to a heat exchanger 5.

With the power converter 1A of the second embodiment, the same basic effects as in the first embodiment can be obtained. In the power converter 1A of the second embodiment, the main circuit heat sink 3A and the auxiliary circuit heat sink 3B are connected in series to each of the coolant paths 25A, 25B, and 25C provided in parallel in the coolant circulation loop 20A. Therefore, for example, cooling by a coolant can be performed for each of functional units corresponding to the main circuit unit 2 and the auxiliary circuit unit 21, and downsizing in individual heat sinks is possible.

### (Third Embodiment)

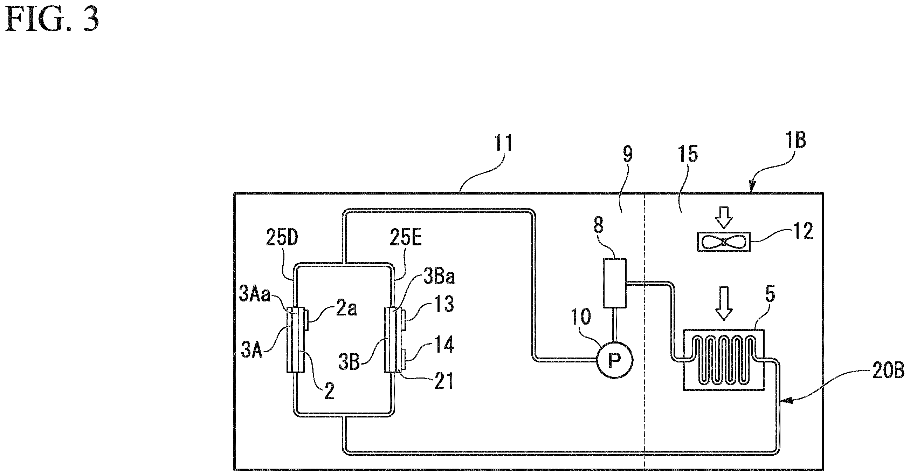

FIG. 3 is a schematic view showing a power converter 1B of a third embodiment when viewed from a lateral side.

Basic configurations of the power converter 1B of the third embodiment are substantially the same as those of the first embodiment, but two branched-off coolant paths 25D and 25E are provided on a downstream side of a pump 10 of a coolant circulation loop 20B. A main circuit heat sink 3A (first heat receiving member) is connected to one coolant path 25D (first coolant path), and an auxiliary circuit heat sink 3B (second heat receiving member) is connected to the other coolant path 25E (second coolant path). The two branched-off coolant paths 25D and 25E join again to be connected to a heat exchanger 5.

With the power converter 1B of the third embodiment, the same basic effects as in the first embodiment can be obtained. Furthermore, in the power converter 1B of the third embodiment, the main circuit heat sink 3A and the auxiliary circuit heat sink 3B are respectively and separately connected to the different coolant paths 25D and 25E provided in parallel in the coolant circulation loop 20B. Therefore, a coolant which has been heated by cooling one of the main circuit unit 2 and the auxiliary circuit unit 21 does not flow into the other. Accordingly, both a semiconductor device 2a of the main circuit unit 2 and a reactor 13 and a resistor 14 on the auxiliary circuit unit 21 in the power converter 1B can be stably cooled.

### (Fourth Embodiment)

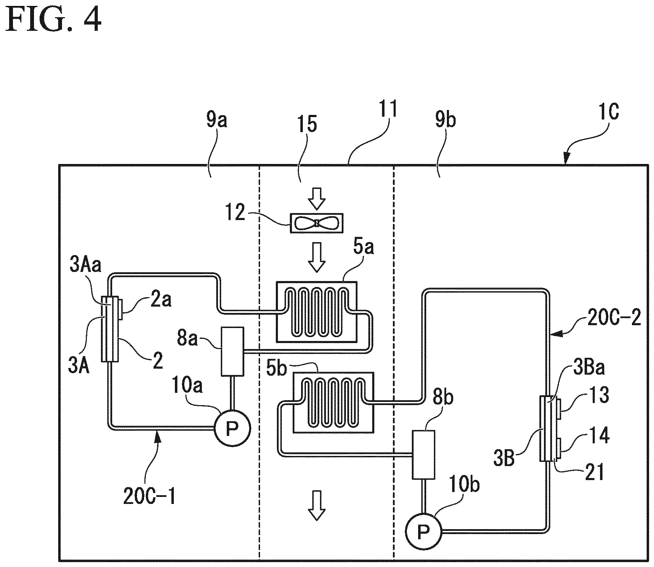

FIG. 4 is a schematic view showing a power converter 1C of a fourth embodiment when viewed from a lateral side.

The power converter 1C of the fourth embodiment includes a first coolant circulation loop 20C-1 to which a main circuit heat sink 3A (first heat receiving member) is connected and a second coolant circulation loop 20C-2 to which an auxiliary circuit heat sink 3B (second heat receiving member) is connected. The first coolant circulation loop 20C-1 is constituted as a separate loop from the second coolant circulation loop 20C-2. A housing 11 of the power converter 1C includes a pair of sealed chambers 9a and 9b separated from each other and a non-sealed chamber 15 disposed between the pair of sealed chambers 9a and 9b.

A main circuit heat sink 3A, and a reservoir tank 8a and a pump 10a of the first coolant circulation loop 20C-1 are disposed in one sealed chamber 9a (first sealed chamber), and an auxiliary circuit heat sink 3B, and a reservoir tank 8b and a pump 10b of the second coolant circulation loop 20C-2 are disposed in the other sealed chamber 9b (second sealed chamber). In the non-sealed chamber 15, a heat exchanger 5a of the first coolant circulation loop 20C-1 and a heat exchanger 5b of the second coolant circulation loop 20C-2 are disposed. A blower 12 is disposed in the non-sealed chamber 15. The heat exchanger 5a of the first coolant circulation loop 20C-1 and the heat exchanger 5b of the second coolant circulation loop 20C-2 are disposed to receive air blown from the common blower 12.

With the power converter 1C of the fourth embodiment, the same basic effects as in the first embodiment can be obtained. The power converter 1C of the fourth embodiment further includes the first coolant circulation loop 20C-1 to which the main circuit heat sink 3A is connected and the second coolant circulation loop 20C-2 to which the auxiliary circuit heat sink 3B is connected. The first coolant circulation loop 20C-1 is constituted as a separate loop from the second coolant circulation loop 20C-2. Also, the heat exchangers 5a and 5b of both loops are disposed to receive air blown from the common blower 12. Therefore, a temperature of a coolant flowing through one of a main circuit unit 2 and an auxiliary circuit unit 21 does not affect a temperature of a coolant flowing through the other. Furthermore, in the non-sealed chamber 15 disposed between the pair of sealed chambers 9a and 9b, the heat exchangers 5a and 5b can be cooled by the common blower 12. Therefore, while high cooling performance for the main circuit unit 2 and the auxiliary circuit unit 21 is maintained, the power converter 1C can be configured to be compact.

### (Fifth Embodiment)

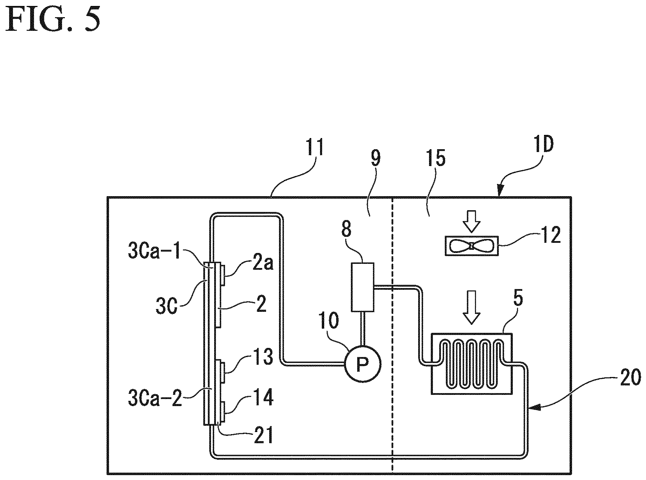

FIG. 5 is a schematic view showing the power converter ID of a fifth embodiment when viewed from a lateral side.

In the power converter 1D of the fifth embodiment, a main circuit heat sink (first heat receiving member) and an auxiliary circuit heat sink (second heat receiving member) are configured as a common heat sink 3C (heat exchange portion) to which a main circuit unit 2 and an auxiliary circuit unit 21 are attached. The heat sink 3C includes a heat exchange portion 3Ca-1 for the main circuit unit 2 and a heat exchange portion 3Ca-2 for the auxiliary circuit unit 21.

With the power converter ID of the fifth embodiment, the same basic effects as in the first embodiment can be obtained. However, in the power converter ID of the fifth embodiment, the heat exchange portion 3Ca-1 for the main circuit unit 2 and the heat exchange portion 3Ca-2 for the auxiliary circuit unit 21 are configured as the common heat sink 3C. Therefore, when this configuration is employed, it is possible to reduce the number of components of the power converter ID and reduce manufacturing costs.

According to at least one embodiment described above, when a main circuit unit having a semiconductor device, a first heat receiving member (main circuit heat sink) to which the main circuit unit is attached, an auxiliary circuit unit having a reactor and a resistor, a second heat receiving member (auxiliary circuit heat sink) to which the auxiliary circuit unit is attached, a coolant circulation loop which causes a coolant to flow through the first heat receiving member and the second heat receiving member, and a heat exchanger which allows heat exchange with respect to the coolant to occur are provided, not only components of the main circuit unit but also components of the auxiliary circuit unit can be cooled efficiently. Accordingly, it is possible to avoid deterioration in performance of the components mounted on the auxiliary circuit unit due to adhesion of dust or the like, and to avoid increase in overall size of the device due to use of a large air-cooling structure.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the inventions. The accompanying claims and their equivalents are intended to cover such forms or modifications as would fall within the scope of the inventions.

### DESCRIPTION OF REFERENCE NUMERALS

1, 1A, 1B, 1C, ID Power converter
2 Main circuit unit
2a Semiconductor device
3A Main circuit heat sink (first heat receiving member)
3B Auxiliary circuit heat sink (second heat receiving member)
3C Heat sink
3Ca-1, 3Ca-2 Heat exchange portion
5 Heat exchanger
9 Sealed chamber
12 Blower
13 Reactor
14 Resistor
15 Non-sealed chamber
20, 20A, 20B Coolant circulation loop
20C-1 First coolant circulation loop
20C-2 Second coolant circulation loop
21 Auxiliary circuit unit
25A, 25B, 25C Coolant path
25D, 25E Coolant path

## Claims

1. A power converter for a railroad vehicle comprising:
a semiconductor device constituting a main circuit unit that carries out power conversion;
a first heat receiving member to which the semiconductor device is attached;
a reactor and a resistor which are electrical components constituting an auxiliary circuit unit that carries out power conversion;
a second heat receiving member to which the reactor and the resistor are attached;
a coolant circulation loop which causes a coolant to flow through the first heat receiving member and the second heat receiving member; and
a heat exchanger which allows heat exchange with respect to the coolant to occur.

2. The power converter for a railroad vehicle according to claim 1, further comprising:
a sealed chamber which is sealed from the outside of the vehicle; and
a non-sealed chamber which is not sealed from the outside of the vehicle, wherein
the first heat receiving member and the second heat receiving member are disposed in the sealed chamber, and
the heat exchanger of the coolant circulation loop is disposed in the non-sealed chamber.

3. The power converter for a railroad vehicle according to claim 1 or claim 2, wherein
the second heat receiving member is connected in series to a downstream side of the first heat receiving member in a coolant path of the coolant circulation loop.

4. The power converter for a railroad vehicle according to claim 3, wherein
a plurality of coolant paths, in each of which the second heat receiving member is connected in series to the downstream side of the first heat receiving member, are provided in parallel in the coolant circulation loop.

5. The power converter for a railroad vehicle according to claim 1 or claim 2, wherein
the first heat receiving member and the second heat receiving member are respectively and separately connected to different coolant paths provided in parallel in the coolant circulation loop.

6. The power converter for a railroad vehicle according to claim 1 or claim 2, further comprising:
a blower capable of blowing air to the heat exchanger, wherein
the coolant circulation loop to which the first heat receiving member is attached and the coolant circulation loop to which the second heat receiving member is attached are constituted as separate loops, and
a first coolant circulation loop to which the first heat receiving member is connected and a second coolant circulation loop to which the second heat receiving member is connected are disposed so that each of heat exchangers thereof receive air blown from the common blower.

7. The power converter for a railroad vehicle according to claim 1 or claim 2, wherein
the first heat receiving member and the second heat receiving member are configured as an integrated heat receiving member which includes a heat exchange portion with respect to the semiconductor device and a heat exchange portion with respect to the reactor and the resistor.
